Europäisches Patentamt

European Patent Office

Office européen des brevets

(19)

(11) Veröffentlichungsnummer : **0 092 720 B1**

# (12) EUROPÄISCHE PATENTSCHRIFT

(45) Veröffentlichungstag der Patentschrift :
18.09.85

(21) Anmeldenummer : 83103453.3

(22) Anmeldetag : 08.04.83

(51) Int. Cl.⁴ : **H 01 L 23/40, H 01 L 23/32**

(54) **Einspannvorrichtung für scheibenförmige Halbleiter-Bauelemente.**

(30) Priorität : 23.04.82 DE 3215192

(43) Veröffentlichungstag der Anmeldung :
02.11.83 Patentblatt 83/44

(45) Bekanntmachung des Hinweises auf die Patenterteilung : 18.09.85 Patentblatt 85/38

(84) Benannte Vertragsstaaten :
AT CH DE FR GB IT LI SE

(56) Entgegenhaltungen :
EP-A- 0 020 911
CH-A- 440 464
DE-A- 2 602 589
FR-A- 2 230 077

(73) Patentinhaber : Siemens Aktiengesellschaft
Berlin und München Wittelsbacherplatz 2
D-8000 München 2 (DE)

(72) Erfinder : Grossmann, Kurt
Thoräcker 18
D-8551 Hallerndorf (DE)
Erfinder : Bliesner, Jürgen
Siemensstrasse 14
D-8551 Hemhofen (DE)
Erfinder : Schikor, Joachim
Kirchenweg 1
D-8521 Uttenreuth (DE)

**Beschreibung**

Die Erfindung betrifft eine Einspannvorrichtung für mehrere scheibenförmige Halbleiter-Bauelemente, die gegen einen Kühlkörper gedrückt werden, wobei der Kühlkörper eine Ausnehmung aufweist und in dieser Ausnehmung ein Druckkörper angeordnet ist, dessen Seitenflächen parallel zu den Innenflächen der Ausnehmung liegen.

Eine derartige Einspannvorrichtung ist beispielsweise aus der CH-A-440 464 bekannt. In dieser Schrift ist ein Kühlkörper beschrieben mit einem pyramidenstumpfförmigen Hohlraum, in dem die Halbleiterelemente untergebracht sind, welche an der Innenfläche des Kühlkörpers angepreßt sind unter Verwendung eines in der Achsrichtung verschiebbaren Keilkörpers.

Bei der Kühlung von Halbleiter-Bauelementen ist ein guter Wärmeübergang zwischen dem Halbleiter-Bauelement und einem Kühlkörper ausschlaggebend. Um den Wärmeübergangswiderstand gering zu halten, werden die Halbleiter-Bauelemente im allgemeinen gegen den Kühlkörper gedrückt. Dies kann z. B. dadurch erfolgen, daß die Halbleiter-Bauelemente mit Hilfe vorstehender Laschen direkt am Kühlkörper festgeschraubt werden. Im allgemeinen wird damit gleichzeitig eine elektrische Kontaktierung zwischen Halbleiter-Bauelement und Kühlkörper erreicht. Mit der direkten Verschraubung des Halbleiter-Bauelements auf den Kühlkörper wird jedoch kein gleichmäßiger Anpreßdruck erreicht, so daß die mit einer derartigen Anordnung abzuführende Verlustleistung begrenzt ist. Außerdem ist die Schraubverbindung jedes einzelnen Halbleiter-Bauelements bei der Montage verhältnismäßig aufwendig.

Zur Abführung höherer Verlustleistungen ist aus der DE-OS 29 26 403 eine Einspannvorrichtung, insbesondere für scheibenförmige Thyristoren bekannt, bei der das Halbleiter-Bauelement zumindest einseitig an einem Kühlkörper anliegt. Es sind zwei Spannbolzen vorhanden, zwischen denen eine Blattfeder angeordnet ist.

Mit dieser Blattfeder wird das Halbleiter-Bauelement gegen einen Kühlkörper gedrückt, wobei zur gleichmäßigen Druckverteilung zwischen Blattfeder und Halbleiter-Bauelement ein Druckstück angeordnet ist. Mit dieser Einspannvorrichtung wird eine sehr gleichmäßige Anpressung des Halbleiter-Bauelements an den Kühlkörper erzielt und es können auch hohe Anpreßdrücke realisiert werden. Mehrere in Serie geschaltete Halbleiter-Bauelemente können aufeinander gestapelt und mit einer gemeinsamen Einspannvorrichtung versehen werden. Für unabhängige oder parallel geschaltete Halbleiter-Bauelemente muß jedoch für jedes Element eine gesonderte Einspannvorrichtung vorgesehen werden. Aufgrund des hohen Aufwands für die Einspannvorrichtung sowie der aufwendigen Montage kommt eine derartige Vorrichtung nur für höhere Leistungen in Betracht.

Aufgabe der Erfindung ist es daher, eine Einspannvorrichtung der eingangs genannten Art so aufzubauen, daß der Aufwand für die Herstellung der Vorrichtung sowie für den Einbau der Halbleiter-Bauelement verringert wird und daß mehrere unabhängig voneinander geschaltete oder parallel geschaltete Halbleiter-Bauelemente platzsparend in eine gemeinsame Einspannvorrichtung eingebaut werden können.

Diese Aufgabe wird erfindungsgemäß dadurch gelöst, daß die Stirnseiten des Druckkörpers mit einem Spannelement zusammendrückbar sind, wobei der Druckkörper senkrecht zu den Innenflächen der Ausnehmung auseinandergedrückt wird und daß die Halbleiter-Bauelemente zwischen den Seitenflächen des Druckkörpers und den Innenflächen der Ausnehmung angeordnet sind.

Bei dieser Einspannvorrichtung sind also die Halbleiter-Bauelemente platzsparend in einer Ausnehmung des Kühlkörpers untergebracht. Wenn der Kühlkörper z. B. luftgekühlt ist, so wird die für die Kühlung maßgebliche Oberfläche des Kühlkörpers durch den Einbau der Halbleiter-Bauelemente nicht verringert, so daß der sonst für die Halbleiter-Bauelemente zur Verfügung stehende Einbauplatz eingespart wird. Die Halbleiter-Bauelemente werden mit dem Druckkörper an die Innenflächen der Ausnehmung angepreßt. Dabei ist sichergestellt, daß der Anpreßdruck gleichmäßig auf alle Halbleiter-Bauelemente verteilt wird, und daß jedes einzelne Halbleiter-Bauelement gleichmäßig an die Innenfläche der Ausnehmung angedrückt wird. Wenn zwischen den Halbleiter-Bauelementen und den Innenflächen der Ausnehmung z. B. eine Isolierfolie eingelegt wird, so können die Halbleiter-Bauelemente völlig unabhängig voneinander geschaltet werden, auch wenn ihr Gehäuse mit einem Anschluß des Halbleiter-Bauelements verbunden ist. Wird dagegen zwischen Halbleiter-Bauelement und Kühlkörper keine Isolierfolie eingelegt, so entsteht gleichzeitig mit dem thermischen Kontakt auch ein elektrischer Kontakt zwischen Halbleiter-Bauelement und Kühlkörper, so daß alle Gehäuse der eingebauten Halbleiter-Bauelement miteinander verbunden sind. Damit wird z. B. eine Parallelschaltung der Halbleiter-Bauelemente erleichtert.

Der Druckkörper kann aus elastisch zusammendrückbarem Material bestehen. Dabei wird der Anpreßdruck besonders gleichmäßig über die Anpreßfläche verteilt und Fertigungstoleranzen werden ausgeglichen.

Ausnehmung und Druckkörper können jeweils die Form eines geraden Prismas haben, wobei an jeder der Seitenflächen des Prismas ein Halbleiter-Bauelement anliegt. Eine derartige Form ist beispielsweise im Strangpreßverfahren besonders einfach zu realisieren.

Ausnehmung und Druckkörper können alternativ jeweils die Form eines Pyramidenstumpfes haben, wobei an jeder Seitenfläche des Pyramidenstumpfes ein Halbleiter-Bauelement anliegt. Eine derartige Form hat den Vorteil, daß entsprechend der Neigung des Pyramidenstumpfes eine Komponente der Spannkraft des Spannelements direkt auf die Halbleiter-Bauelemente wirkt, während bei der Form des Prismas lediglich die durch Verformung des Druckkörpers entstehenden Querkräfte wirksam werden.

Der Druckkörper kann alternativ auch aus mindestens zwei parallel zu den Innenflächen der Ausnehmung gegeneinander verschiebbaren Keilen bestehen. Beim Zusammenspannen der Stirnseiten der Keile mit dem Spannelement werden die Seitenflächen auseinandergedrückt und damit die Halbleiter-Bauelemente an den Kühlkörper gepreßt. Mit derartigen Keilen können auch sehr hohe Anpreßdrücke realisiert werden.

Das Spannelement kann aus zwei, jeweils an einer Stirnfläche des Druckkörpers anliegenden Spannscheiben und einer die beiden Spannscheiben verbindenden Spannschraube bestehen.

Zur Realisierung des Spannelements kann alternativ der Kühlkörper in seiner Ausnehmung einen Auflagebolzen für eine Stirnseite des Druckkörpers aufweisen und die zweite Stirnseite des Druckkörpers an einer Leiterplatte anliegen, auf die der Kühlkörper geschraubt ist. In diesem Fall wird also mit Schraubverbindungen gleichzeitig der Kühlkörper an der Leiterplatte befestigt und der Druckkörper zusammengespannt.

Vorteilhafterweise kann der Kühlkörper zylinderförmig sein und an seiner Außenseite in Längsrichtung des Zylinders verlaufende Kühlrippen aufweisen. Damit erhält man eine sehr kompakte Anordnung eines Luftkühlkörpers mit eingebauten Halbleiter-Bauelementen.

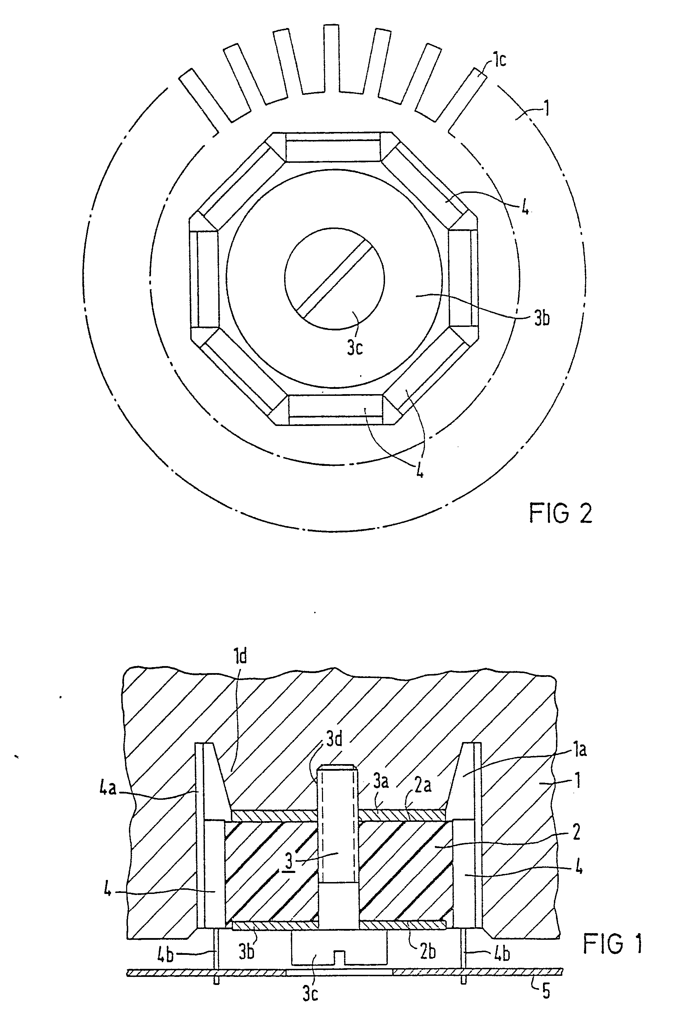

Ausführungsbeispiele der Erfindung werden nachfolgend anhand der Figuren 1 bis 7 näher erläutert.

Figur 1 zeigt eine Schnittdarstellung eines Kühlkörpers 1 mit einer Ausnehmung 1a. Figur 2 zeigt eine Ansicht desselben Kühlkörpers 1 von unten. Die Ausnehmung 1a hat im Ausführungsbeispiel die Form eines geraden, achteckigen Prismas. An jeder Seitenfläche des Prismas liegt ein Halbleiter-Bauelement 4, beispielsweise ein scheibenförmiger Transistor mit einer angesetzten Montagelasche 4a an. Die Anschlüsse des Transistors ragen nach unten aus der Ausnehmung 1a heraus und sind im Ausführungsbeispiel mit Leiterbahnen einer Leiterplatte 5 verlötet.

Der Raum zwischen den Transistoren 4 ist mit einem Druckstück 2 ausgefüllt, das ebenfalls die Form eines achteckigen, geraden Prismas hat und dessen Seitenflächen parallel zu den Innenflächen der Ausnehmung 1a liegen. Als Material für das Druckstück 2 kann beispielsweise EPTM-Gummi verwendet werden. Damit liegt also jeder Transistor 4 mit einer Fläche am Kühlkörper 1 und mit einer Fläche am Druckstück 2 an. Auf den Stirnflächen 2a und 2b des Druckstücks liegt jeweils eine Spannscheibe 3a bzw. 3b, wobei zentrisch durch die Spannscheiben 3a und 3b sowie das Druckstück 2 eine Schraube 3c geführt ist. Das Ende der Schraube 3c führt in ein Gewinde-Sackloch 3d eines in die Ausnehmung 1a des Kühlkörpers 1 hineinragenden Ansatzes 1d des Kühlkörpers 1. Wenn nun die Schraube 3c mit dem Ansatz 1d des Kühlkörpers verschraubt wird, so wird der Druckkörper 2 über die Spannscheiben 3a und 3b zusammengedrückt. Da der Druckkörper 2 elastisch zusammendrückbar ist, weicht er unter dem Druck auf seine Stirnflächen 2a, 2b seitlich aus, d.h. er wird gegen die Halbleiter-Bauelemente 4 gedrückt. Damit werden die Halbleiter-Bauelemente 4 ihrerseits gegen die Innenwände der Ausnehmung 1a des Kühlkörpers 1 gepreßt. Die vom Druckstück 2 auf die Halbleiter-Bauelemente 4 ausgeübte Querkraft verteilt sich gleichmäßig über die Fläche sämtlicher Halbleiter-Bauelemente 4, so daß diese gleichmäßig an den Kühlkörper 1 angepreßt werden. Dabei werden gleichzeitig mäßliche Toleranzen der Transistoren sowie der gesamten Einspannvorrichtung ausgeglichen. An die Fertigungstoleranzen der Einbauvorrichtung werden daher nur sehr geringe Anforderungen gestellt, so daß der Kühlkörper 1 beispielsweise durch Strangpressen ohne mechanische Nachbearbeitung hergestellt werden kann. Es kann z. B. von einem stranggepreßten Kühlprofil abgeschnitten werden.

Der Kühlkörper 1 muß nicht unbedingt eine eigene Befestigung aufweisen. Er wird vielmehr über die in der Leiterplatte 5 verlöteten Anschlüsse der Transistoren 4 und die Verbindung zwischen den Transistoren 4 und dem Kühlkörper 1 für die meisten Anwendungsfälle ausreichend gehalten.

Bei den in Frage kommenden scheibenförmigen Halbleiter-Bauelementen ist im allgemeinen ein Anschluß, z. B. der Kollektor mit dem Gehäuse des Halbleiter-Bauelements verbunden. Mit der erfindungsgemäßen Einspannvorrichtung werden dann über den Kühlkörper 1 alle Kollektoren der Halbleiter-Bauelemente miteinander verbunden, wenn man zwischen Halbleiter-Bauelement und Kühlkörper keine Isolierung vorsieht. Wenn eine derartige Verbindung nicht erwünscht ist, weil z. B. die Kollektoren auf unterschiedlichem Potential liegen, so kann man zwischen die Halbleiter-Bauelemente 4 und den Kühlkörper 1 eine Isolierfolie einlegen, so daß die Halbleiter-Bauelemente 4 zwar mit dem Kühlkörper 1 in gut wärmeleitender Verbindung stehen, jedoch elektrisch isoliert sind.

Wie in Figur 2 sichtbar, weist der Kühlkörper 1 einen kreisförmigen Querschnitt auf, an dessen Außenseite Kühlrippen 1c angebracht sind. Der Kühlkörper 1 ist für Luftkühlung mit natürlicher Luftzirkulation ausgelegt. Man könnte jedoch den Kühlkörper 1 ebensogut mit Kühlkanälen, z. B. in Form von Durchbrüchen versehen, durch die Wasser oder ein gasförmiges Kühlmedium fließt. Die dargestellte Einspannvorrichtung läßt sich also sowohl für Kühlkörper mit Kühlung durch natürliche Luftzirkulation als auch für Kühlkörper mit Zwangskühlung durch Kühlflüssigkeit oder Kühlgas verwenden. In jedem Fall erhält man durch Unterbringung der Halbleiter-Bauelemente in einer Aussparung des Kühlkörpers einen sehr kompakten Aufbau. Dabei ist darauf hinzuweisen, daß bei einem Kühlkörper mit Luftkühlung über Kühlrippen trotz des Einbaus der Halbleiter-Bauelemente in eine Aussparung die für die Wärmeabfuhr maßgebliche äußere Oberfläche nicht verringert wird. Ist der Kühlkörper mit Kühlkanälen versehen, so kann ein sehr geringer Abstand zwischen Kühlkanälen und Halbleiter-Bauelement und damit ein sehr guter Wärmeübergang erreicht werden.

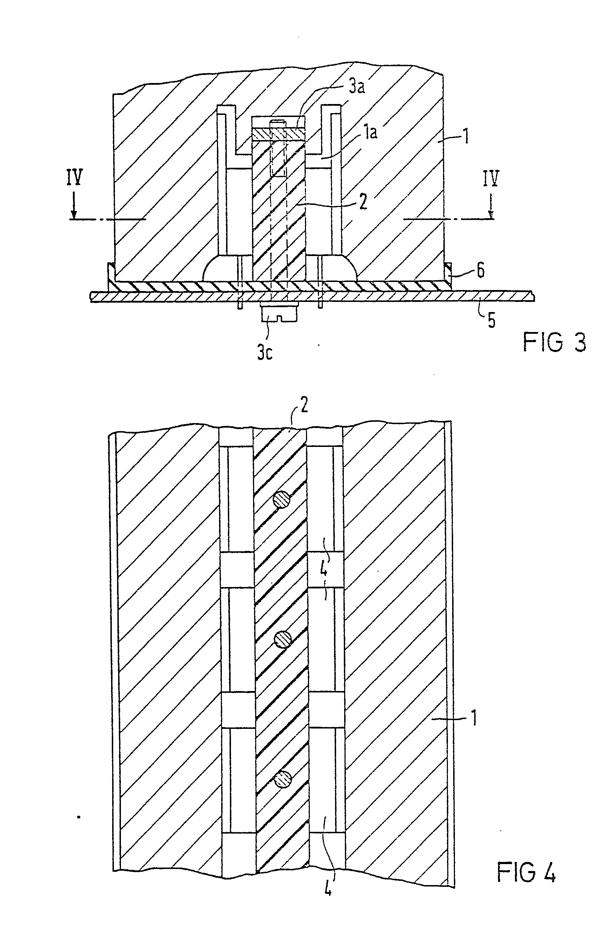

Ein weiteres Ausführungsbeispiel der Erfindung ist in den Figuren 3 und 4 dargestellt. Dabei stellt Figur 3 einen Schnitt durch den Kühlkörper 1 und Figur 4 einen weiteren Schnitt längs der Linie IV-IV nach Figur 3 dar. Der Kühlkörper 1 ist in diesem Fall in wesentlichen schienenförmig mit einer nutförmigen Ausnehmung 1a ausgeführt, wobei beliebig viele Halbleiter-Bauelemente 4 aneinandergereiht werden können. Im Unterschied zur Ausführung nach Figur 1 wird der Druckkörper 2 nicht auf einen Vorsprung in der Ausnehmung 1a des Kühlkörpers 1 aufgeschraubt, sondern zwischen die Leiterplatte 5 und eine auf der gegenüberliegenden Stirnseite des Druckkörpers 2 liegende Spannscheibe 3a mit einer Spannschraube 3c eingespannt. Auch dabei wird der Druckkörper 2 beim Festziehen der Schraube 3c seitlich auseinandergedrückt und preßt die Halbleiter-Bauelemente 4 gegen den Kühlkörper 1. Dabei erhält man den Vorteil, daß mit der Schraube 3c auch der Kühlkörper 1 auf der Leiterplatte 5 festgehalten wird. Da der Kühlkörper 1 auf dem Potential eines der Anschlüsse der Halbleiter-Bauelemente 4 liegt, ist zwischen Leiter-platte 5 und Kühlkörper 1 noch ein Isolierteil 6 zwischengelegt.

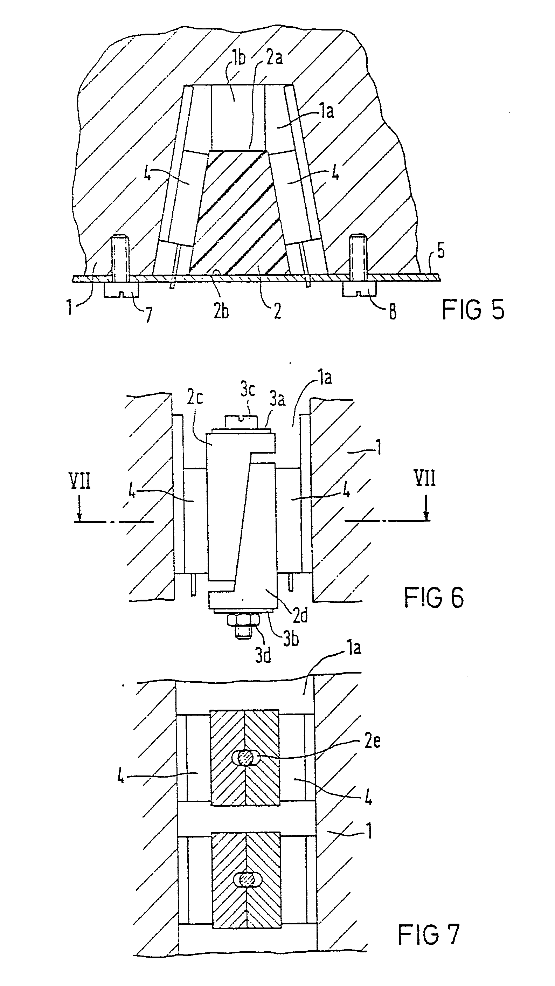

Figur 5 zeigt ein drittes Ausführungsbeispiel der Erfindung. Dabei weisen die Ausnehmung 1a des Kühlkörpers 1 und der Druckkörper 2 jeweils die Form eines Pyramidenstumpfes auf, wobei an jeder Seitenfläche des Pyramidenstumpfes ein Halbleiter-Bauelement 4 anliegt. Eine Stirnseite des Druckstücks 2 liegt an einem Vorsprung 1b in der Ausnehmung 1a des Kühlkörpers 1 an. Die zweite Stirnseite 2b des Druckkörpers 2 liegt auf der Leiterplatte 5 auf und ist mit Schrauben 7, 8 befestigt. In diesem Fall wird der Druckkörper 2 zwischen dem Vorsprung 1b und der Leiterplatte 5 zusammengedrückt, wenn die Schrauben 7 und 8 angezogen werden. Der sich seitlich ausdehnende Druckkörper 2 übt dabei ebenfalls eine Querkraft auf die Halbleiter-Bauelemente 4 aus und drückt diese gegen die Innenwände der Ausnehmung 1a. Darüber hinaus wirkt bei dieser Ausführungsform entsprechend der Neigung des Pyramidenstumpfes aber auch eine Komponente der auf den Druckkörper 2 aufgebrachten Sprannkraft direkt auf die Halbleiter-Bauelemente 4. Mit der Ausführungsform nach Figur 5 lassen sich also höhere Anpreßdrücke erzielen. Außerdem hat diese Ausführungsform wie auch die Ausführungsform nach Figur 3 den Vorteil, daß die Einspannung des Druckstücks 2 und die Befestigung des Kühlkörpers 1 mit denselben Schrauben 7, 8 erfolgt.

Ein weiteres Ausführungsbeispiel der Erfindung ist in den Figuren 6 und 7 dargestellt. Diese Figuren zeigen Schnitte einer Einspannvorrichtung aus zwei verschiedenen Richtungen. Dabei ist der Druckkörper aus zwei Keilen 2c und 2d zusammengesetzt, deren Schrägflächen so aufeinander liegen, daß die Seitenflächen parallel zu den Innenwänden der Ausnehmung 1a des Kühlkörpers 1 liegen. Die Keile 2c und 2d sind gegeneinander verschiebbar und weisen jeweils eine Bohrung 2e mit ovalem Querschnitt auf. In diesen Bohrungen 2e liegt eine Schraube 3c, die zusammen mit einer Mutter 3d als Spannelement dient. Dabei sind an beiden Stirnseiten der Keile 2c und 2d Spannscheiben 3a bzw. 3b untergelegt. Um eine saubere Auflage für die Spannscheiben 3a und 3b zu erzielen sind die Keile 2c und 2d an ihren Stirnseiten verbreitert. Mehrere derartige Einspannvorrichtungen mit beidseitig anliegenden Halbleiter-Bauelementen 4 können in der nutförmigen Ausnehmung 1a des Kühlkörpers 1 aneinandergereiht werden.

Wenn man die Schraube 3c anzieht, d. h. die Keile 3c und 3d gegeneinander verschiebt, so werden diese in Richtung auf die Innenwände der Ausnehmung 1a auseinandergedrückt und pressen damit die Halbleiter-Bauelemente 4 gegen diese Innenwände. Mit dieser Anordnung kann ein sehr hoher Anpreßdruck für die Halbleiter-Bauelemente 4 realisiert werden.

**Patentansprüche**

1. Einspannvorrichtung für mehrere scheibenförmige Halbleiter-Bauelemente, die gegen einen Kühlkörper gedrückt werden, wobei der Kühlkörper (1) eine Ausnehmung (1a) aufweist und in dieser Ausnehmung (1a) ein Druckkörper (2) angeordnet ist, dessen Seitenflächen parallel zu den Innenflächen der Ausnehmung (1a) liegen, dadurch gekennzeichnet, daß die Stirnseiten (2a, 2b) des Druckkörpers (2) mit einem Spannelement (3) zusammendrückbar sind, wobei der Druckkörper (2) senkrecht zu den Innenflächen der Ausnehmung (1a) auseinandergedrückt wird und daß die Halbleiter-Bauelemente (4) zwischen den Seitenflächen des Druckkörpers (2) und den Innenflächen der Ausnehmung (1a) angeordnet sind.

2. Einspannvorrichtung nach Anspruch 1, dadurch gekennzeichnet, daß der Druckkörper (2) aus elastisch zusammendrückbarem Material besteht.

3. Einspannvorrichtung nach Anspruch 2, dadurch gekennzeichnet, daß Ausnehmung (1a) und Druckkörper (2) jeweils die Form eines geraden Prismas haben, wobei an jeder der Seitenflächen des Prismas ein Halbleiter-Bauelement (4) anliegt.

4. Einspannvorrichtung nach Anspruch 2, dadurch gekennzeichnet, daß Ausnehmung (1a) und Druckkörper (2) jeweils die Form eines Pyramidenstumpfes haben, wobei an jeder Seitenfläche des Pyramidenstumpfes ein Halbleiter-Bauelement (4) anliegt.

5. Einspannvorrichtung nach Anspruch 1, dadurch gekennzeichnet, daß der Druckkörper (2) aus mindestens zwei parallel zu den Innenflächen der Ausnehmung (1a) gegeneinander verschiebbaren Keilen (2c, 2d) besteht.

6. Einspannvorrichtung nach einem der Ansprüche 1 bis 5, dadurch gekennzeichnet, daß das Spannelement (3) aus zwei, jeweils an einer Stirnfläche des Druckkörpers (2) anliegenden Spannscheiben (3a, 3b) und einer die beiden Spannscheiben (3a, 3b) verbindenden Spannschraube (3c) besteht.

7. Einspannvorrichtung nach einem der Ansprüche 1 bis 6, dadurch gekennzeichnet, daß zur Realisierung des Spannelements (3) der Kühlkörper (1) in seiner Ausnehmung (1a) einen Auflagebolzen (1b) für eine Stirnseite (2a) des Druckkörpers (2) aufweist und daß die zweite Stirnseite (2b) des Druckkörpers (2) an einer Leiterplatte (5) anliegt, auf die der Kühlkörper (1) geschraubt ist.

8. Einspannvorrichtung nach einem der Ansprüche 1 bis 7, dadurch gekennzeichnet, daß der Kühlkörper (1) zylinderförmig ist und an seiner Außenseite in Längsrichtung des Zylinders verlaufende Kühlrippen (1c) aufweist.

## Claims

1. Clamp assembly for holding a plurality of disc-shaped semiconductor elements pressed against a heat sink, the heat sink (1) having a recess (1a), there being arranged in this recess (1a) a compression means (2), having side faces which are parallel to inside faces of the recess (1a), characterised in that end faces (2a, 2b) of the compression means (2) may be acted on by a tension means (3) so that the side faces of the compression means (2) are urged outwardly towards the inside faces of the recess (1a) ; and in that the semiconductor elements (4) are arranged between the side faces of the compression means (2) and the inside faces of the recess (1a).

2. Clamp assembly according to claim 1, characterised in that the compression means (2) is made of elastically compressible material.

3. Clamp assembly according to claim 2, characterised in that the recess (1a) and the compression means (2) are both in the form of a straight-sided prism, a semiconductor element (4) abutting each of the side faces of the prism.

4. Clamp assembly to claim 2, characterised in that the recess (1a) and the compression means (2) are both in the form of a truncated pyramid, a semiconductor element (4) abutting each side face of the truncated pyramid.

5. Clamp assembly according to claim 1, characterised in that the compression means (2) comprises at least two wedges (2c, 2d), displaceable with respect to each other in a direction which is parallel to the inside faces of the recess (1a).

6. Clamp assembly according to any of claims 1 to 5, characterised in that the tension means (3) comprises two washers (3a, 3b), each abutting one end face of the compression means (2), and a screw (3c) connecting the two washers (3a, 3b).

7. Clamp assembly according to any one of claims 1 to 6, characterised in that to produce the tension means (3), the heat sink (1) has in its recess (1a) a support bolt (1b) for one end face (2a) of the compression means (2) ; and in that the opposite end face (2b) of the compression means (2) abuts a conductive plate (5) which is screwed onto the heat sink (1).

8. Clamp assembly according to any one of claims 1 to 7, characterised in that the heat sink (1) is in the form of a cylinder and has on its outside cooling ribs (1c) which extend in the longitudinal direction of the cylinder.

## Revendications

1. Dispositif de serrage pour des composants à semiconducteurs ayant la forme de disques, et qui sont pressés contre un radiateur, le radiateur (1) comportant une cavité (1a) et, dans cette cavité (1a) un corps de pression (2) dont les surfaces latérales sont parallèles aux surfaces intérieures de la cavité (1a), caractérisé par le fait que les côtés frontaux (2a, 2b) du corps de pression (2) sont susceptibles d'être comprimés avec un élément de serrage (3), le corps de pression (2) étant dilaté perpendiculairement aux surfaces intérieures de la cavité (1a), et que le composant à semiconducteurs (4) est disposé entre les surfaces latérales du corps de pression (2) et les surfaces intérieures de la cavité (1a).

2. Dispositif de serrage selon la revendication 1, caractérisé par le fait que le corps de pression (2) est constitué avec un matériau qui est susceptible d'être comprimé élastiquement.

3. Dispositif de serrage selon la revendication 2, caractérisé par le fait que la cavité (1a) et le corps de pression (2) ont respectivement la forme d'un prisme droit, un composant à semiconducteurs (4) portant contre chaque surface latérale du prisme.

4. Dispositif de serrage selon la revendication 2, caractérisé par le fait que la cavité (1a) et le corps de pression (2) ont respectivement la forme d'un tronc de pyramide, un composant à semiconducteurs (4) portant contre chacune des surfaces latérales du tronc de pyramide.

5. Dispositif de serrage selon la revendication 1, caractérisé par le fait que le corps de pression (2) est constitué par au moins deux coins (2c, 2d) qui sont susceptibles d'être déplacés entre eux parallèlement aux surfaces intérieures de la cavité (1a).

6. Dispositif de serrage selon l'une des revendications 1 à 5, caractérisé par le fait que l'élément de serrage (3) est constitué par deux disques de serrage (3a, 3b) portant respectivement contre une surface frontale du corps de pression (2), et par une vis de serrage (3c) qui relie les deux disques de serrage (3a, 3b).

7. Dispositif de serrage selon l'une des revendications 1 à 6, caractérisé par le fait que pour réaliser l'élément de serrage (3), le radiateur (1) comporte, dans sa cavité (1a), un boulon d'appui (1b) pour un côté frontal (2a) du corps de pression (2) et que le second côté frontal (2b) du corps de pression (2) porte contre une plaque à circuits imprimés (5) sur laquelle le radiateur (1) est vissé.

8. Dispositif de serrage selon l'une des revendications 1 à 7, caractérisé par le fait que le radiateur (2) a la forme d'un cylindre et comporte, sur son côté extérieur des nervures de refroidissement (1c) qui s'étendent dans la direction longitudinale du cylindre.

FIG 2

FIG 1

FIG 3

FIG 4

FIG 5

FIG 6

FIG 7

3